# EUROPEAN PATENT SPECIFICATION

(11) **EP 0 402 897 B1**
(45) Date of publication and mention of the grant of the patent: **19.08.1998**
(21) Application number: 90111198.9
(22) Date of filing: 13.06.1990
(51) Int. Cl.: H01L 21/768, H01L 21/32

(54) **Method of manufacturing semiconductor device having elements isolated by trench**
Verfahren zur Herstellung von Halbleiteranordnungen mit durch Graben isolierten Komponenten
Procédé pour la fabrication de dispositifs semi-conducteurs comportant des composants isolés par des rainures

(30) Priority: 14.06.1989 JP 151542/89
(43) Date of publication of application: 19.12.1990
(73) Proprietor: KABUSHIKI KAISHA TOSHIBA, Kawasaki-shi, Kanagawa-ken 210 (JP)
(72) Inventor: Miyashita, Naoto, c/o Intellectual Property Div., Minato-ku, Tokyo 105 (JP); Takahashi, Koichi, c/o Intellectual Property Div., Minato-ku, Tokyo 105 (JP); Sonobe, Hironori, c/o Intellectual Property Div., Minato-ku, Tokyo 105 (JP)
(74) Representative: Lehn, Werner, Dipl.-Ing.

(56) References cited:
- EP-A- 0 078 725
- EP-A- 0 135 354
- US-A- 4 876 214
- PATENT ABSTRACTS OF JAPAN vol. 009, no. 298 (E-361)26 November 1985

## Description

The present invention relates to a method of manufacturing a semiconductor device such as a semiconductor integrated circuit having elements isolated by a trench.

In a conventional semiconductor integrated circuit, a plurality of element regions electrically isolated from each other are arranged on a major surface of a semiconductor substrate. An active element such as a transistor and a passive element such as a resistor are formed on these element regions. The element regions are isolated from each other by a trench, a p-n junction, an oxide film, and the like. A prior art wherein an integrated circuit is manufactured by an element isolation method using a trench will be described below.

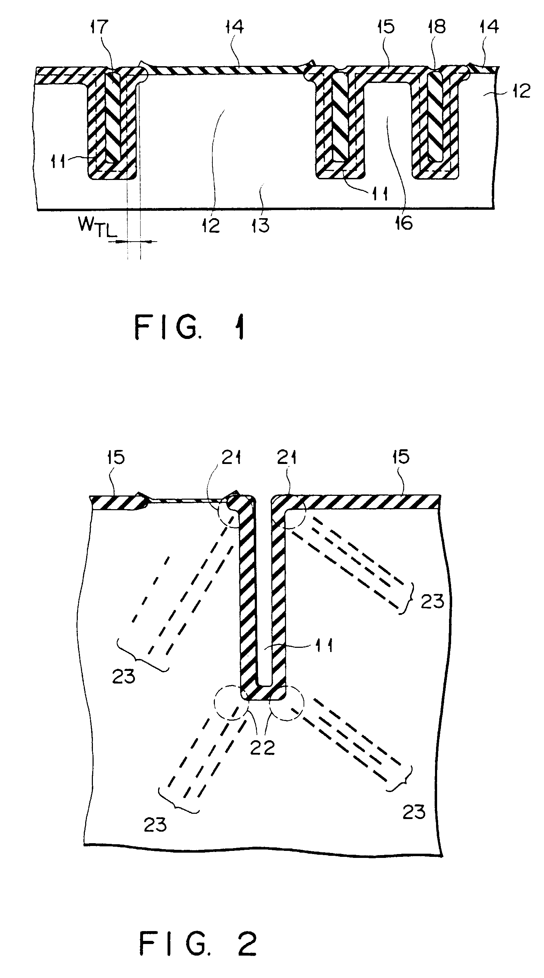

As shown in Fig. 1, a trench 11 is formed to surround an element region 12 of an Si substrate 13 by anisotropic etching. A nonoxide film 14 such as a silicon nitride (SiNₓ) film is selectively formed on the upper surface of the element region 12. Thermal oxidation is performed for the resultant structure using the nonoxide film 14 as a mask to form an oxide film 15 on the inner surface of the trench 11 and the upper surface of a field region 16. Thereafter, a polysilicon layer 17 is buried in the trench 11, and after the surface of the polysilicon layer 17 is flattened, a capping oxide film 18 is formed on the trench 11.

In order to improve integration of elements, an interval W_{TL} between the end of the nonoxide film 14 and the first side wall (indicated by broken line in Fig. 1) of the trench 11 is generally designed to be minimized. The interval W_{TL} is conventionally selected from the range of 0 µm to 1 µm. However, when the interval W_{TL} is too small, dislocation defects 23 may be extended in the inside of the substrate from corner portions 21 of the upper portion of the trench 11 and corners 22 of the bottom by stress concentration upon formation of the oxide film 15 by thermal oxidation, as shown in Fig. 2.

The dislocation defects cause degradation of isolation characteristics between element regions and characteristics of elements formed on the element regions. For example, when a bipolar transistor is formed on each of the element regions, the presence of dislocation defects causes a leak current of each transistor to increase or causes various characteristics such as collector current (Ic) vs. current amplification factor (h_{FE}) characteristics to degrade. More specifically, when dislocation defects are present at a given density, a recombination current is increased using defects as the center of recombination, thereby degrading characteristics of the element or element isolation characteristics.

EP-A-0135354 shows forming a trench, forming an oxide film in the trench, forming a polysilicon filler in the trench, forming a nonoxide filler in an area surrounded by the trench and forming an oxide film on the filler using the nonoxide film as an anti-oxidation mask.

EP-A-0078725 shows minimising lateral encroachment of the oxide layer by making it thinner than one micron. JP-A-601 36327 shows using a residual nitride film as a mask for the oxide film.

It is an object of the present invention to provide a method of manufacturing a semiconductor device wherein defects such as dislocations generated in a substrate are suppressed and element characteristics and element isolation characteristics are not substantially degraded.

According to one aspect of the present invention, there is provided a method of manufacturing a semiconductor device, comprising steps of:
forming a trench having a width of 1 to 2 µm, in a monocrystalline silicon substrate to surround an element forming region by anisotropic etching;
forming a nonoxide film on said element forming region such that an interval between an end portion of said nonoxide film and a said wall of said trench at a side near said element forming region of said trench is not less than 2 µm;
forming an oxide film having a thickness of less than 900 nm on a surface of said substrate including an inside of said trench using said nonoxide film as a mask during selective oxidation, and forming a dielectric material in the trench.

Other aspects of the invention are set out in claims 2 and 3.

This invention can be more fully understood from the following detailed description when taken in conjunction with the accompanying drawings, in which:
Fig. 1 is a sectional view showing an integrated circuit manufactured by a conventional method;
Fig. 2 is a sectional view for explaining a problem of the conventional manufacturing method;
Figs. 3A to 3C are sectional views showing steps in manufacturing an integrated circuit according to a method of the present invention;
Fig. 3D is a perspective view showing the integrated circuit manufactured by the method according to the present invention;
Fig. 4 is a graph for explaining the present invention;
Fig. 5 is a graph for explaining the present invention; and
Fig. 6 is a graph for explaining the present invention.

The present inventors made extensive studies and obtained the following findings. That is, an element isolation structure using a trench is formed by the following manner. After a trench is formed in a semiconductor substrate, oxide films are simultaneously or independently formed in the trench and on the upper surface of a field region by thermal oxidation using a nonoxide film such as an SiNₓ film as a mask, and a dielectric material such as polysilicon is filled in the trench upon oxidation. Thereafter, the surface of the polysilicon is flattened, and the exposed surface of the dielectric material is oxidized to form a capping oxide film. In the element isolation structure, a density of defects such as dislocation extending from the corner of the trench mainly depends on an interval (interval W_{TL} in Fig. 1) between the end of the nonoxide film and the first side wall of the trench. A density of defects such as dislocation extending from the corners of the trench also depends on the thickness of an oxide film formed on a field region or the inner surface of the trench. According to an attempt to be described later, the thickness of the oxide film formed by oxidizing the field region and the inner surface of the trench and the interval between the end of the nonoxide film and the first side wall of the trench are defined, thereby surely suppressing dislocation defects extending from the corners of the trench. Therefore, element characteristics and element isolation characteristics are not substantially degraded.

As an embodiment of a method of manufacturing a semiconductor device of the present invention, a case wherein a bipolar transistor is formed in an element region will be described below.

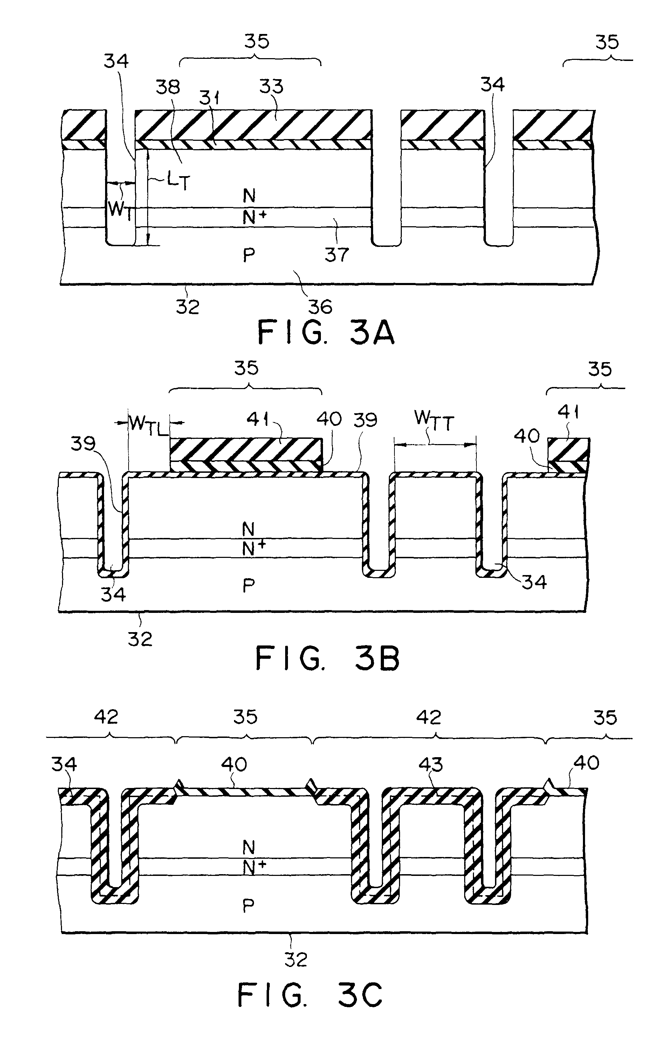

As shown in Fig. 3A, an SiO₂ film 31 having a thickness of 70-100 nm (700 to 1,000 Å) is formed on the major surface of a monocrystalline silicon substrate 32 by CVD or thermal oxidation. A resist pattern 33 having an opening on a region for forming a trench for isolating elements is formed in the SiO₂ film 31, and a plurality of trenches 34 each having a width W_{T} of about 1 to 2 µm and a depth of about 5 µm are formed vertically in the substrate to surround a plurality of element regions 35. Note that the monocrystalline silicon substrate 32 is constituted by, e.g., a p-type epitaxial layer 36, an n+-type buried layer 37 formed on the epitaxial layer 36, and an n-type layer 38 formed on the n+-type buried layer 37.

The resist pattern 33 is removed by, e.g., an O₂ asher, and the SiO₂ film 31 is removed by, e.g., diluted hydrofluoric acid. As shown in Fig. 3B, thermal oxidation is performed for the resultant structure in a gas mixture of H₂ and O₂ at a temperature of 950°C to form an SiO₂ film 39 having a thickness of about 50 nm (500 Å) on the entire surface of the resultant structure. In addition, a 150 nm (1,500 Å) monoxide film 40 such as a silicon nitride (SiNₓ) film is deposited at a temperature of 780°C by LP-CVD (Low Pressure-CVD). A resist pattern 41 is formed on the nonoxide film 40 by photoetching, and the nonoxide film 40 is plasma-etched to leave it on only the plurality of element regions 35. In this case, the device is designed to have an interval (W_{TL} in Fig. 3B) having at least 2 µm or more between the end of the remaining nonoxide film 40 and a side wall of each trench 34 at a side near the element region 35. At the same time, the device is designed to have an interval (W_{TT} in Fig. 3B) having about 3 µm between side walls of the adjacent trenches 34.

As shown in Fig. 3C, the resist pattern 41 is removed by, e.g., an O₂ asher in the same manner as described above, and wet oxidation is performed at a temperature of 1,000°C using the nonoxide film 40 as a mask to continuously form, e.g., oxide films 43 each having a thickness of less than 900 nm (9,000 Å), eg., 800 nm (8,000 Å), on field regions 42 respectively located between the element regions 35 and the trenches 34 and on the side walls of trenches 34.

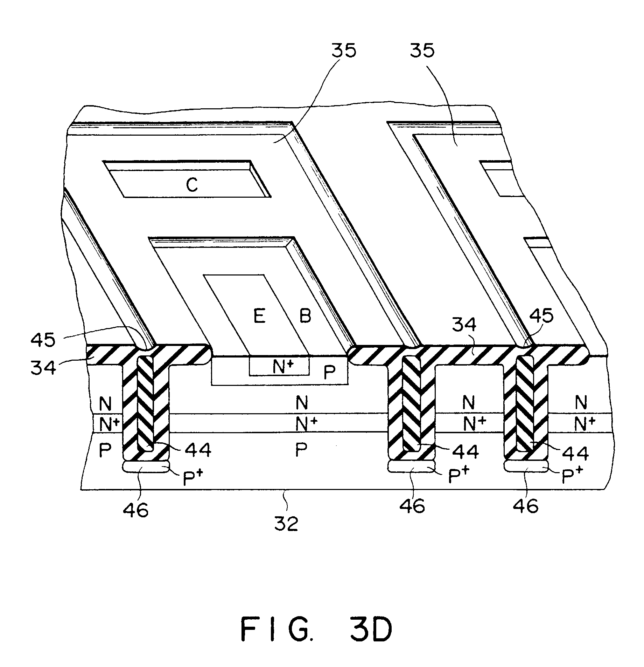

As shown in Fig. 3D, a polysilicon layer 44 is buried by, e.g., LP-CVD in the trenches 34 in which the oxide films 43 are formed. After the surface of the polysilicon layer 44 is flattened, the exposed surface of the polysilicon layer 44 is oxidized to form a thin capping oxide film 45. A bipolar transistor is formed on each of the plurality of element regions 35 by the known method. Note that reference symbols E, B, and C denote emitter, base, and collector regions of the bipolar transistor, respectively. Although not described above, after formation of the trenches 34, p⁺-type channel cut regions 46 are respectively formed in the bottoms of the trenches by ion implantation or diffusion.

An attempt performed in the process for achieving the present invention will be described below. In order to optimize the interval W_{TL} between the end of the nonoxide film 40 and the side wall of each trench 34 at a side near the element region 35, the interval W_{TL} was set to be various values, and characteristics of an integrated circuit wherein a plurality of bipolar transistors were formed on the substrate by the above described method were estimated. At this time, the intervals W_{TL} were 0 µm, 1 µm, 2 µm, 3 µm, and 4 µm, the thickness of all the oxide films 43 on the field region 42 was 900 nm (9,000 Å), and the interval (W_{TT} in Fig. 3B) between the trenches was 3 µm. As estimation items included densities of defects generated at corner portions of the top and bottom of each trench, a stress applied around each trench at room temperature, and a leak voltage generated between elements.

The above defect density was represented as follows. After completion of all element forming steps, the entire surface of the substrate was etched to expose the trench, and defects present on the exposed surface of the trench were selectively etched by wright etching or the like. Thereafter, the number of defects was visually counted using an optical microscope, and the number was represented as a defect density per 1-mm trench length. The stress was measured by Micro-Raman-Spectroscopy, and a maximum stress applied to the bottom of the trench was represented as a measured value. In addition, a leak current was calculated from voltage vs. current characteristics between both the collector electrodes of two transistors, and the leak current was represented as a leak current density between elements at a voltage of 12 V.

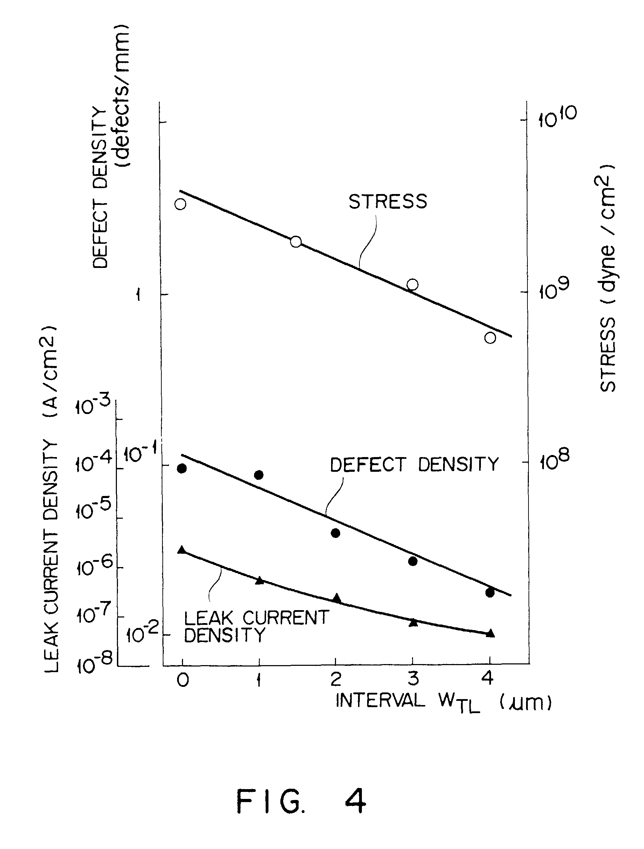

These characteristics are summarized in Fig. 4. The abscissa in Fig. 4 represents the interval W_{TL} (µm), and the ordinate represents the leak current density (A/cm²) between transistors at a voltage of 12 V, the defect density (defects/mm), and the stress (dyne/cm²).

As is apparent from Fig. 4, it is found that, when the interval W_{TL} is gradually decreased from 4 µm to 3 µm, 2 µm, 1 µm, and 0 µm, the stress is gradually increased and the defect density is also increased accordingly. It is found that, with an increase in defect density, leak current density representing a degree of degradation of element isolation characteristics is also increased. Since the leak current density must be kept at a low level, the interval W_{TL} must be increased as much as possible. However, since an increase in interval W_{TL} causes an increase in area of the field region, the interval cannot be excessively increased. Therefore, the minimum interval W_{TL} must be defined.

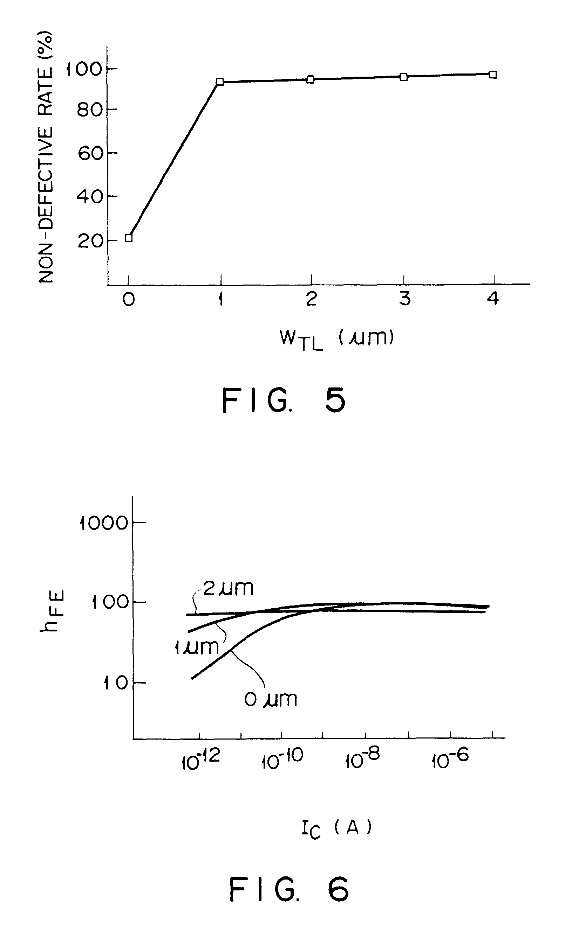

Fig. 5 shows a relationship between the interval W_{TL} and a non-defective rate of transistors in a case wherein 200 to 500 npn transistors are formed on one silicon substrate. In this case, a non-defective element has a collector current I_{CEO} of 1 µA or less when a voltage of 5 V is applied between the collector and emitter electrodes and the base electrode is open. As is apparent from Fig. 5, when the interval W_{TL} is gradually decreased from 4 µm to 3 µm, 2 µm, and 1 µm, a non-defective rate is gradually decreased. When the interval is 0 µm, the non-defective rate is rapidly decreased. Therefore, according to this characteristic, the minimum interval W_{TL} is given as 1 µm.

Fig. 6 shows collector current (Ic) vs. current amplification factor (h_{FE}) characteristics of an npn transistor formed on a silicon substrate using the interval W_{TL} as a parameter. That is, the abscissa represents the collector current Ic (A), and the ordinate represents the current amplification factor h_{FE}. Note that the h_{FE} falls within the range of 80 to 100. As is apparent from Fig. 6, when the interval W_{TL} is smaller than 2 µm, h_{FE} is decreased in a region having a low collector current. However, when the interval W_{TL} is 2 µm or more, a decrease in h_{FE} is not conspicuous in the region having the low collector current, and the h_{FE} falls within a design value. Therefore, according to the characteristics, the minimum interval W_{TL} is given as 2 µm. According to the above result, when bipolar transistors are formed on element regions, the interval W_{TL} must be 2 µm or more in order to obtain the sufficiently satisfactory characteristics of the transistors.

In a bipolar transistor, the thickness of the oxide film formed on the field region and the side walls of the trench by wet oxidation is generally designed to be less than 900 nm (9,000 Å). When the silicon substrate is generally oxidized, the oxide film extends outside the surface of the substrate by about 45% of its total thickness and extends inside the surface of the substrate by about 55% of its total thickness. Therefore, the trench is designed to have the width W_{T} of 1 µm as described above, and an oxide film having a thickness of 800 nm (8,000 Å) is formed by wet oxidation. As a result, an oxide film having a thickness of 800 nm (8,000 Å) × 0.45, i.e., 360 nm (3,600 Å) is formed on the first surface of the trench. Using an oxide film having the above thickness, the trench is not buried by only the oxide film. Therefore, a polysilicon layer can be formed in the trench.

Another embodiment of the present invention will be described below.

In this embodiment, each of trenches 34 has a width W_{T} of 1 to 2 µm and a depth L_{T} of about 5 µm, an interval W_{TL} between the end of a nonoxide film 40 and the side wall of the trench 34 is at least 2 µm or more, and an oxide film 43 has a thickness of less than 900 nm (9,000 Å), e.g., 800 nm (8,000 Å). In the field of integrated circuits, the size of an element is generally reduced by a technique called shrinkage. In this technique, the integrated circuit is designed to have sizes obtained by multiplying a predetermined magnification, e.g., 0.8 or 0.7, by a standard size, and all the sizes are reduced proportionally to the magnification.

Therefore, in the embodiment wherein shrinkage is performed at a magnification of 0.8 for the integrated circuit designed and manufactured by the above embodiment in Fig. 3, each trench 34 has a width W_{T} of 0.8 to 1.6 µm and a depth L_{T} of about 4 µm, an interval W_{TL} between the end of a nonoxide film 40 and the side wall of a trench 34 is at least 1.6 µm or more, and the thickness of an oxide film 43 is designed to have less than 720 nm (7,200 Å) eg., 700 nm (7,000 Å). In addition, in the embodiment wherein shrinkage is performed at a magnification of 0.7 for the integrated circuit designed and manufactured by the above embodiment in Fig. 3, each trench 34 has a width W_{T} of 0.7 to 1.4 µm and a depth L_{T} of about 3.5 µm, an interval W_{TL} between the end of a nonoxide film 40 and the side wall of a trench 34 is at least 1.4 µm or more, and the thickness of an oxide film 43 is designed to have less than 630 nm (6,300 Å) eg., 600 nm (6,000 Å).

Note that the present invention is not limited to the above embodiments and can be variously changed. For example, in the embodiment in Fig. 3, although a case wherein oxide films are simultaneously formed inside the trench and on the upper surface of the field region has been described above, the oxide films may be independently formed inside the trench and on the upper surface of the field region.

## Claims

1. A method of manufacturing a semiconductor device, comprising the steps of:
forming a trench (34) having a width (W_{T}) of 1 to 2 µm, in a monocrystalline silicon substrate (32) to surround an element forming region by anisotropic etching;
forming a nonoxide film (40) on said element forming region such that an interval (W_{TL}) between an end portion of said nonoxide film and a side wall of said trench at a side near said element forming region of said trench is not less than 2 µm;
forming an oxide film (43) having a thickness of less than 900 nm (9,000 Å) on a surface of said substrate including an inside of said trench using said nonoxide film as a mask during selective oxidation, and forming a dielectric material in the trench.

2. A method of manufacturing a semiconductor device, comprising the steps of:
forming a trench having a width (W_{T}) of 0.8 to 1.6 µm in a monocrystalline silicon substrate (32) to surround an element forming region by anisotropic etching;
forming a nonoxide film (40) on said element forming region such that an interval (W_{TL}) between an end portion of said nonoxide film and a side wall of said trench at a side near said element forming region of said trench is not less than 1.6 µm;
forming an oxide film (43) having a thickness of less than 720 nm (7,200 Å) on a surface of said substrate including an inside of said trench using said nonoxide film as a mask during selective oxidation; and
forming a dielectric material in the trench.

3. A method of manufacturing a semiconductor device, comprising the steps of:
forming a trench having a width (W_{T}) of 0.7 to 1.4 µm, in a monocrystalline silicon substrate (32) to surround an element forming region by anisotropic etching;
forming a nonoxide film (40) on said element forming region such that an interval (W_{TL}) between an end portion of said nonoxide film and a side wall of each trench at a side near said element forming region of said trench is not less than 1.4 µm;
forming an oxide film (43) having a thickness of less than 630 nm (6,300 Å) on a surface of said substrate including an inside of said trench using said nonoxide film as a mask during selective oxidation; and
forming a dielectric material in the trench.

4. A method according to claim 1, 2, or 3, characterized in that at least a bipolar transistor is formed in said element forming region.

## Patentansprüche

1. Ein Verfahren zum Herstellen einer Halbleitervorrichtung, umfassend die Schritte:
Bilden eines Grabens (34) der einer Breite (W_{T}) von 1 bis 2 µm aufweist, in einem monckristallinem Siliziumsubstrat (32) durch anisotropes Ätzen, um eine elementbildende Region zu umgeben;
Bilden eines Nichtoxidfilmes (40) auf der elementbildenden Region, so daß ein Abstand (W_{TL}) zwischen einem Endabschnitt des Nichtoxidfilmes und einer Seitenwand des Grabens an einer Seite nach der elementbildenden Region des Grabens nicht kleiner als 2 µm ist;
Bilden eines Oxidfilmes (43), der eine Dicke von weniger als 900 nm (9000 Å) aufweist, auf einer Oberfläche des Substrates, einschließlich einer Innenseite des Grabens, unter Verwendung des Nichtoxidfilmes als Maske während selektiver Oxidation, und Bilden eines dielektrischen Materials in dem Graben.

2. Ein Verfahren zum Herstellen einer Halbleitervorrichtung, umfassend die Schritte:
Bilden eines Grabens, der eine Breite (W_{T}) von 0,8 bis 1,6 µm aufweist, in einem monokristallinem Siliziumsubstrat (32) durch anisotropes Ätzen, um eine elementbildende Region zu umgeben;
Bilden eines Nichtoxidfilmes (40) auf der elementbildenden Region, so daß ein Abstand (W_{TL}) zwischen einem Endabschnitt des Nichtoxidfilmes und einer Seitenwand des Grabens an einer Seite nahe der elementbildenden Region des Grabens nicht kleiner als 1,6 µm ist;
Bilden eines Oxidfilmes (43), der eine Dicke von weniger als 720 nm (7200 Å) aufweist, auf einer Oberfläche des Substrates, einschließlich einer Innenseite des Grabens, unter Verwendung des Nichtoxidfilmes als Maske während selektiver Oxidation; und
Bilden eines dielektrischen Materials in dem Graben.

3. Ein Verfahren zum Herstellen einer Halbleitervorrichtung, umfassend die Schritte:
Bilden eines Grabens, der eine Breite (W_{T}) von 0,7 bis 1,4 µm aufweist, in einem monokristallinen Siliziumsubstrat (32) durch anisotropes Ätzen, um eine elementbildende Region zu umgeben;
Bilden eines Nichtoxidfilmes (40) auf der elementbildenden Region, so daß ein Abstand (W_{TL}) zwischen einem Endabschnitt des Nichtoxidfilmes und einer Seitenwand von jedem Graben an einer Seite nahe der elementbildenden Region des Grabens nicht kleiner 1,4 µm ist;
Bilden eines Oxidfilmes (43), der eine Dicke von weniger als 630 nm (6300 Å) aufweist, auf einer Oberfläche des Substrates, einschließlich einer Innenseite des Grabens, unter Verwendung des Nichtoxidfilmes als Maske während einer selektiver Oxidation; und
Bilden eines dielektrischen Materials in dem Graben.

4. Ein Verfahren nach Anspruch 1, 2 oder 3,
**dadurch gekennzeichnet, daß**
mindestens ein Bipolartransistor in der elementbildenden Region ausgebildet ist.

## Revendications

1. Procédé de fabrication d'un dispositif à semiconducteurs, comprenant les étapes consistant à :
former une tranchée (34) présentant une largeur (W_{T}) de 1 à 2 µm, dans un substrat de silicium monocristallin (32) afin d'entourer une région de formation d'élément par gravure anisotrope,
former un film inoxydable (40) sur ladite région de formation d'élément de sorte qu'un intervalle (W_{TL}) entre une partie d'extrémité dudit film inoxydable et une paroi latérale de ladite tranchée au niveau du côté proche de ladite région de formation d'élément de ladite tranchée, ne soit pas inférieur à 2 µm,
former un film d'oxyde (43) présentant une épaisseur inférieure à 900 nm (9 000 Å) sur une surface dudit substrat y compris l'intérieur de ladite tranchée, en utilisant ledit film inoxydable en tant que masque durant une oxydation sélective, et former un matériau diélectrique dans la tranchée.

2. Procédé de fabrication d'un dispositif à semiconducteurs, comprenant les étapes consistant à :
former une tranchée présentant une largeur (W_{T}) de 0,8 à 1,6 µm dans un substrat de silicium monocristallin (32) afin d'entourer une région de formation d'élément par gravure anisotrope,
former un film inoxydable (40) sur ladite région de formation d'élément de sorte qu'un intervalle (W_{TL}) entre une partie d'extrémité dudit film inoxydable et une paroi latérale de ladite tranchée au niveau du côté proche de ladite région de formation d'élément de ladite tranchée, ne soit pas inférieur à 1,6 µm,
former un film d'oxyde (43) présentant une épaisseur inférieure à 720 nm (7 200 Å) sur une surface dudit substrat y compris l'intérieur de ladite tranchée, en utilisant ledit film inoxydable en tant que masque durant une oxydation sélective, et
former un matériau diélectrique dans la tranchée.

3. Procédé de fabrication d'un dispositif à semiconducteurs, comprenant les étapes consistant à :
former une tranchée présentant une largeur (W_{T}) de 0,7 à 1,4 µm, dans un substrat de silicium monocristallin (32) afin d'entourer une région de formation d'élément par gravure anisotrope,
former un film inoxydable (40) sur ladite région de formation d'élément de sorte qu'un intervalle (W_{TL}) entre une partie d'extrémité dudit film inoxydable et une paroi latérale de chaque tranchée au niveau d'un côté proche de ladite région de formation d'élément de ladite tranchée, ne soit pas inférieur 1,4 µm,
former un film d'oxyde (43) présentant une épaisseur inférieure 630 nm (6 300 Å) sur une surface dudit substrat y compris l'intérieur de ladite tranchée en utilisant ledit film inoxydable en tant que masque durant une oxydation sélective, et
former un matériau diélectrique dans la tranchée.

4. Procédé selon la revendication 1, 2 ou 3, caractérisé en ce qu'au moins un transistor bipolaire est formé dans ladite région de formation d'élément.
